# EUROPEAN PATENT SPECIFICATION

(11) **EP 2 324 365 B1**
(45) Date of publication and mention of the grant of the patent: **23.04.2014**
(21) Application number: 09786749.3
(22) Date of filing: 30.07.2009
(51) Int. Cl.: G01R 31/36, H01M 10/48

(54) **APPARATUS AND METHOD FOR ANALYSING THE STATE OF MAINTENANCE AND EFFICIENCY OF BATTERIES, ESPECIALLY FOR INDUSTRIAL AND/OR COMMERCIAL VEHICLES**
VORRICHTUNG UND VERFAHREN ZUR ANALYSE DES WARTUNGS- UND LEISTUNGSZUSTANDS VON BATTERIEN, INSBESONDERE FÜR INDUSTRIE- UND/ODER NUTZFAHRZEUGE
APPAREIL ET PROCÉDÉ POUR L'ANALYSE DE L'ÉTAT DE MAINTENANCE ET DE L'EFFICACITÉ DES BATTERIES, EN PARTICULIER POUR DES VÉHICULES INDUSTRIELS ET/OU COMMERCIAUX

(30) Priority: 01.08.2008 EP 08425535
(43) Date of publication of application: 25.05.2011
(73) Proprietor: Iveco S.p.A., 10156 Torino (IT)
(72) Inventor: CERRATO, Roberto, I-10094 Giaveno (IT); POLETTO, Paolo, I-10095 Grugliasco (IT)
(74) Representative: Gervasi, Gemma
(86) International application number: PCT/IB2009/053308
(87) International publication number: WO 2010/013212

(56) References cited:
- EP-A- 0 233 638
- DE-A1- 19 834 740
- US-A- 6 084 523
- US-A1- 2003 020 479
- US-A1- 2003 040 873
- US-A1- 2003 169 019
- US-A1- 2004 251 907
- US-A1- 2005 143 955
- US-A1- 2006 284 619
- US-A1- 2007 182 576

## Description

### Field of the invention

The present invention relates to an apparatus and method for analysing the state of maintenance and efficiency of batteries, especially for an industrial and/or commercial vehicle.

### Description of the prior art

The battery installed on board vehicles, especially industrial and/or commercial vehicles, has at least three purposes:
- starting the engine;
- supplying the energy support to the vehicle in the event of malfunctioning of the engine or of the alternator, for example, for the following systems: check on engine; check on braking; lighting / light signalling, intermittent lights, light system, above all in the cases of emergency, and
- guaranteeing usability of the services in the cab (heating, radio, ventilation, etc.) when the vehicle is standing still, even with the engine turned off.

It is hence evident that the battery plays a fundamental role in the context of proper operation of the vehicle.

An intrinsic behaviour of the battery is the reduction of the performance over time. If properly maintained, the life expectancy of the battery can be significantly long (e.g., longer than four years); otherwise, it may drop to just a few months.

The battery tends to run down easily also with the engine turned off, given the high and increasing number of on-board electronic apparatuses that need to be supplied even when the engine is turned off, whether they are in stand-by or are turned on.

Battery maintenance is fundamental especially in the initial steps, during the period of warranty, and also subsequently. The absence of maintenance entails an increase in the costs of general management and under warranty.

For example, in the case of need for assistance on the vehicle due to the battery, to the direct costs for battery replacement there may be added the ones deriving from the possible need to tow the vehicle.

The rate of degeneration of the performance of the battery is fast so that it is necessary to make frequent checks on its characteristics such as to provide objective data, and it must be possible to keep track on all the steps of the checks to be able to trace the effective origin of the problems also for reasons of responsibility under warranty or during maintenance contract.

There is hence the need to provide both a system and an objective procedure for checking the state of the batteries that will be carried out with sufficient frequency, and will not depend upon individual "sensations" or decisions, for example, of the driver or the person responsible for maintenance.

Previous uses of storage means integrated in vehicle batteries are known in the art, as for example in US2003/040873-A1 and US2007/182576-A1. These systems, however do not guarantee a complete and effective operating functionality. In particular, the system of US2003/040873 is described in the preamble of the claim 1.

### Summary of the invention

Consequently, the purpose of the present invention is to provide a system for analysing the state of maintenance and efficiency of batteries, especially for industrial and/or commercial vehicles, that will enable the performance of the battery to be guaranteed over time, according to claim 1.

A particular subject of the present invention is a system for analysing the state of maintenance and efficiency of batteries, especially for industrial and/or commercial vehicles, as will be described more fully in the annexed claims, which form an integral part of the present description.

### Brief description of the Figures

The purposes and advantages of the present invention will emerge clearly from the ensuing detailed description of an example of embodiment thereof (and of its variants), as well as from the annexed drawings, provided purely by way of non-limiting explanation, in which:
figures 1.1 and 1.2 show a block diagram of the system for analysing the state of maintenance and efficiency of batteries, especially for industrial and/or commercial vehicles, that is subject of the invention;
- figures 2.1, 2.2, 2.3, 3.1, 3.2, 3.3, 3.4 show flowcharts of the operations performed for analysing the state of maintenance and efficiency of the battery in accordance with the invention.

### Detailed description of preferred embodiments of the invention

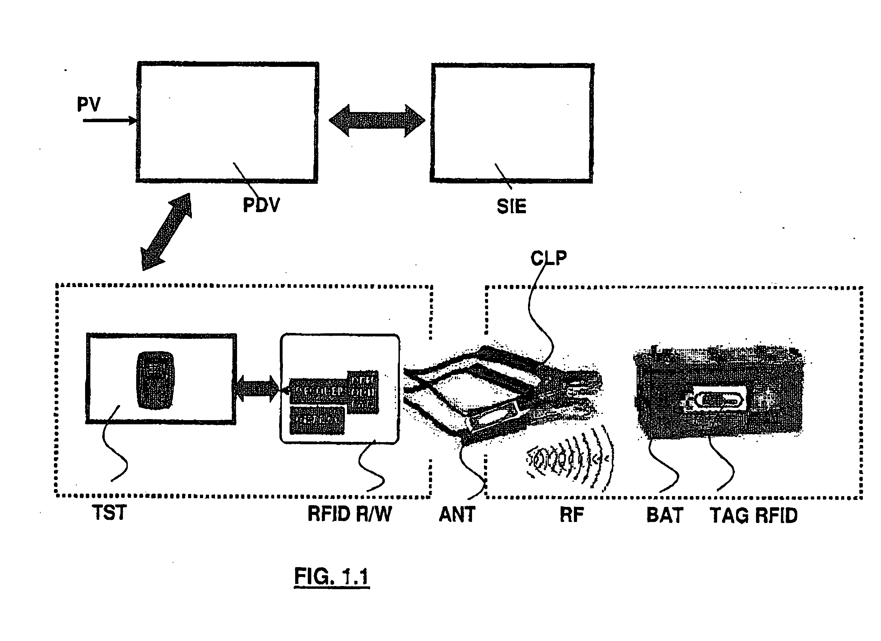

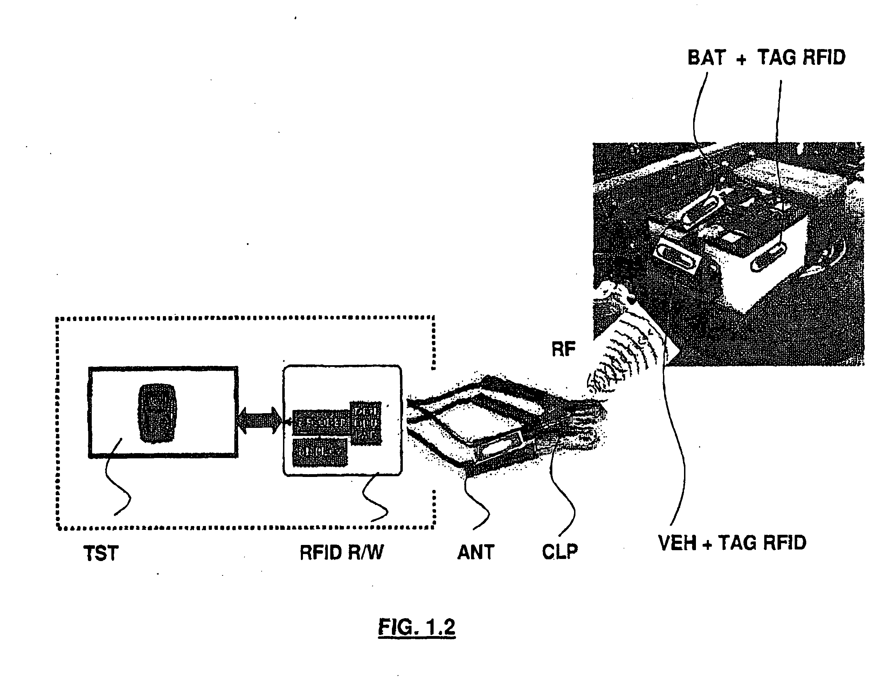

The apparatus forming the subject of the invention is now described in detail with reference to its principal constituent modules highlighted in figure 1.

The apparatus enables to store in the battery information for keeping track of the maintenance operations performed on the battery, and basically comprises the following elements:
A) A battery BAT, modified in accordance with the invention, i.e. integrated in which is a device, referred to in what follows as RFID TAG, to be applied on the battery, which is the storage unit that stores the maintenance operations and the identification information, in order to make available an electronic tag fixed to the battery. It should be noted that more than one battery can be installed on a single vehicle; for example, there may often be two batteries installed on an industrial and/or commercial vehicle; hence such a device can be integrated in each of the batteries.
B) An instrument for measuring the characteristics of the battery, i.e., a tester TST of a type in itself known, for making electrical measurements on the battery, for example equipped with cables and clamps CLP for connection to the battery terminals, and designed to make measurements, for example of the following parameters:
   - maximum current that can be delivered by the battery so as to be able to guarantee a sufficient voltage supply for the electrical and electronic loads, also guaranteeing starting of the engine at low temperatures;
   - residual or remaining capacity: i.e., the maximum amount of energy that can be accumulated in the battery.
C) A device for reading and writing the RFID TAG, referred to in what follows as RFID R/W.
D) A vehicle diagnostic platform PDV, of a type in itself known, designed to interface in a known way with the vehicle electronic control unit for reading the vehicle parameters PV, and designed to interface with the RFID R/W for reading the information necessary for keeping track of the battery-maintenance operations.
E) A possible external information system SIE that drives and controls the different operations, for example the vehicle diagnostic platform PDV.
   It is to be noted that the system SIE can also include the PDV.
F) A possible centralized server, for enabling storage of the data obtained, for example via the Internet, designed to interact with one or more vehicle diagnostic platforms PVD or with the information system SIE.

More in particular, as regards the RFID TAG device the following specifications are made.

RFID (Radio Frequency Identification) is a technology for automatic identification of objects that may even be animated. The system is based upon remote reading and/or writing of information from/in a read/write element, referred to as RFID TAG, or also as transponder, which is substantially constituted by:
- a microchip containing data (amongst which a universal unique number)
- an antenna
- a possible battery.
The RFID TAG is able to receive the information contained in the chip and transmit it via radiofrequency to a RFID transceiver, referred to as RFID R/W.

There exist different types of RFID TAGs, substantially of types in themselves known, which work at normalized frequencies, for example, 125/134 kHz, 13.56 MHz, 868/915 MHz, >2.4 GHz.

Some are of a passive type; others are active or semi-active. The active ones are supplied by batteries, whereas the semi-active ones are supplied by batteries only to maintain the internal circuit part active whilst for irradiation they use a part of the energy received from the radio wave that also transmits the information, whilst the passive ones do not have internal sources of supply, but draw energy from the radio wave sent by the RFID R/W that queries them to be activated and retransmit the data.

The microchip (of very small dimensions) is the "smart" part, constituted by a non-volatile memory containing a single code, which is transmitted via the antenna (signal-transmission circuit) to the apparatus RFID R/w, which controls the received data.

In the passive type, the RFID R/W emits an electromagnetic field, which, via the process of induction, generates in the antenna a current that supplies the microchip. The latter communicates all its information, which is irradiated via the antenna to the RFID R/W.

The active types, instead, are supplied by a small internal battery (active RFIDs).

The read/write mode enables not only a transmission of information but also updating thereof on the microchip. There is thus obtained an identification system that can keep track of the history of a product right from the production step and then be used in an interactive way throughout the process up to retail distribution and in some cases up to the consumer.

The transponder and antenna are inserted in a support that characterizes the specific use of each of these objects. Different types of embodiments of RFID TAGs are known in the art: inserted in labels or within cards of a credit-card format, or else in the form of stickers, etc.

More in particular, the device RFID R/W, which in this context is of the passive type, is constituted by a circuit that emits radiofrequency electromagnetic energy RF by means of an antenna ANT, and by an electronics that receives and decodes the information sent by the transponder RFID TAG and sends it to the data-collection system. The communication between the RFID TAG and the RFID R/W takes place in four steps:
a) the RFID R/W energizes the RFID TAG;
b) the RFID R/W issues commands for querying the RFID TAGs that can be reached;
c) the RFID R/W listens to the replies of the RFID TAGs;
d) the RFID R/W communicates the result of the reading to the outside world.

The communication between the RFID R/W and the RFID TAGs that can be reached is made by means of the antenna ANT, which is the element that irradiates the electromagnetic signal. The antenna is of a type in itself known but its design depends upon the particular use, namely upon the spectrum of frequencies used, the conditions of installation of the RFID TAG in the battery, the distance with respect to the RFID TAG, in order to determine proper coupling between the chip and the antenna.

Moreover in a possible embodiment, the RFID R/W component may be inserted along the connection cable between the tester TST and the clamp CLP. In fact the cable may overall be very long, according to specific needs, while the distance between the RFID R/W and the antenna should be limited and predetermined, in order to limit as much as possible the radiofrequency losses between the amplifier and the antenna. Since, as described below, it is preferable to integrate the antenna in the clamps CLP of the tester, RFID R/W may be inserted in the splitting point of the connection cable between the tester TST and the clamps CLP, where the cable is splitted in two ends, one for each clamp, in order to link the distance of the clamps CLP to the characteristics of the emission of the antenna. On the contrary, the portion of cable between the tester TST and RFID R/W may be on any length. According to an aspect of the invention, the RFID TAG is integrated in the battery, in different possible modes, e.g., in the lid, or else floating within the battery liquid, or adhesive with protective coating that reveal any attempts at tampering.

The RFID TAG is integrated in the battery lid, for example by using an ultrasound-welded case. It is also possible to add a bar code on the case, as reduntant identification. It is also preferable to vertically place the RFID TAG, in order to avoid that water or steam stagnates on it and then ices and lowers its transmitting capacity.

According to a further aspect of the invention, with reference to figure 1.2, a further vehicle VEH RFID TAG is inserted, preferably in a point of the vehicle near the battery compartment (fig. 1.2 shows a part of a vehicle which includes a battery compartment with two batteries). It will be generally equipped with a lower storage capacity than the RFID TAG of the batteries BAT, since it will be devoted to contain only the identification data of the vehicle (vehicle VIN). As explained in detail below, preferably a reading both of the battery RFID TAG and of the vehicle VEH RFID TAG will be performed.

According to a further aspect of the invention, the antenna ANT is preferably integrated in the clamps CLP of the tester TST and more in particular in the clamp of the negative pole: in this position it is possible to obtain an optimal irradiation diagram and a reduction of the interference or of noise problems. The negative pole is normally without additional connection which can limit the application of the RFID TAG, and is therefore able to guarantee a correct reading/writing of the RFID TAG itself.

In this position the antenna is, while it is working, in the most equidistant point from all the RFID TAGs involved in the measurement, namely the battery RFID TAG and the vehicle RFID TAG, in order to energize them at the wanted distance and to guarantee the reading and writing operations.

Generally, it is preferable to provide a reading/writing of a short-range type, for different reasons: e.g. to prevent the TAGs of other nearby vehicles from possibly being read or written, or to prevent fraudulent readings, etc. On the other hand, if the distance is too short or too long, the field irradiated by the antenna risks not to be picked up, since on the clamp the antenna may also be too much far away from some RFID TAGs or be in shadow zones for others. The antenna should, in fact, be able to be connected to more RFID TAGs: the one on the battery, on which the clamp is applied, the other possible battery, and the one of the vehicle. If the antenna manages to reach all the elements, it is in optimal conditions, therefore it manages to correctly identify on which RFID TAG it has to perform the reading/writing operations. The vehicle VEH RFID TAG may, as said, be applied to a point near the battery compartment, but may also be applied to any other point in the vehicle: in both cases there is a variation of the initial procedure for validating the correspondence among the vehicle identification data described below.

As regards the type of information that can be stored in the RFID TAG during the manufacturing of the battery, which can be considered as the initial time t=0, in the RFID TAG are stored the identification data of the type of battery, like for example: model; manufacturing date / lot; rating, information on service, for example whether the destinations of use are hot or cold climates; testing date.

There are also performed different operations of checking, like short-circuit current, whose result may be stored in the electronic tag.

During the steps of production of the vehicle and of installation of the battery on board, it is possible to associate the battery to the vehicle via data stored in the RFID TAGs, for example the vehicle identification number (VIN). The obvious advantage is that of being able to link vehicle/battery and vehicle mission, and hence that of being able to provide weighted diagnostic information on the type of use. For example, the fatigue of a battery for a city vehicle is very different from that of a vehicle for motorway use (from one engine start every 10 km travelled to one engine start every 200 km travelled).

During the subsequent steps of maintenance and check of the battery, track is kept on maintenance life of the battery, which, for instance, may be distinguished between before and after delivery to the end customer, i.e., between the moment of production and that of actual use of the vehicle. Keeping track of the maintenance life consists in executing operations of checking followed by diagnostic indications and indications of intervention. Then, these details are also saved in RFID TAGs.

Having available vehicle diagnostic information matched with the information on board the battery (filed in the electronic tag and updated, for example, at the moment of updating of the periodic-maintenance coupon) enables a diagnostic approach that up to now was not possible: for example, it becomes possible to identify the state of efficiency or of health of the battery and of its compatibility with the type of mission of the vehicle. Given the results, there derives therefrom the possibility of recommending maintenance operations and/or replacement of the battery or diagnostic suggestions; for example it is possible for the external information system SIE to send warning e-mails when the date of the periodical tests approaches.

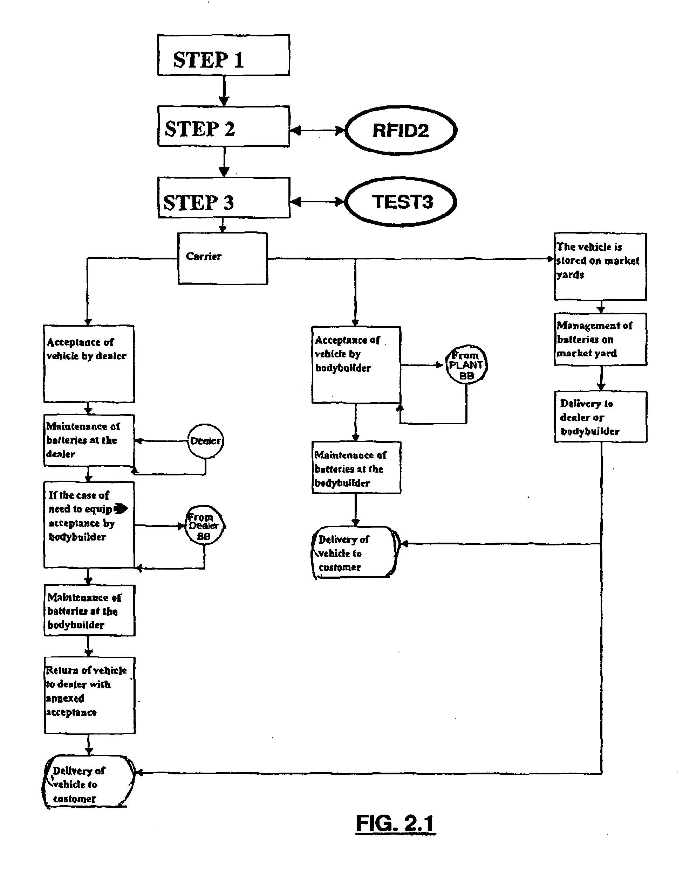

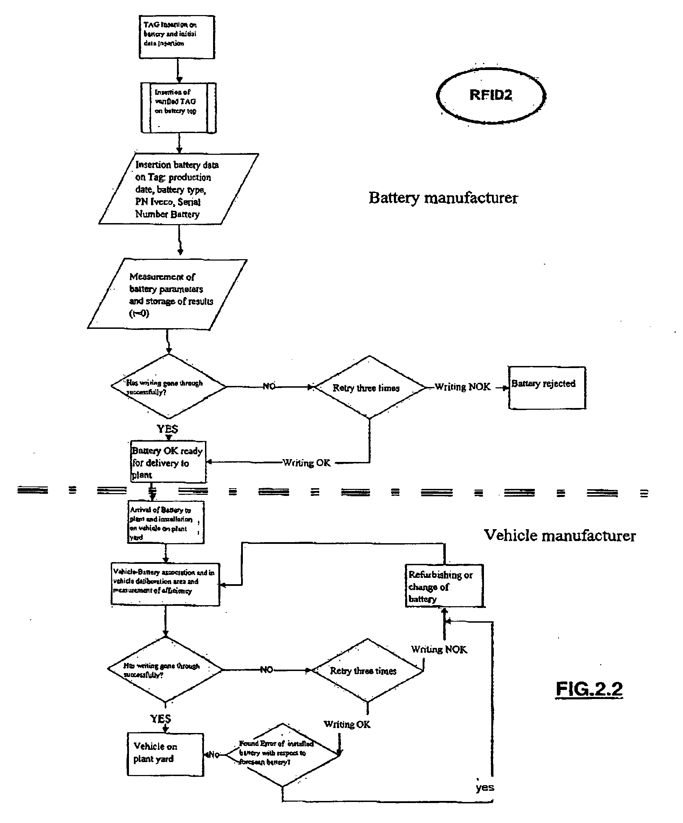

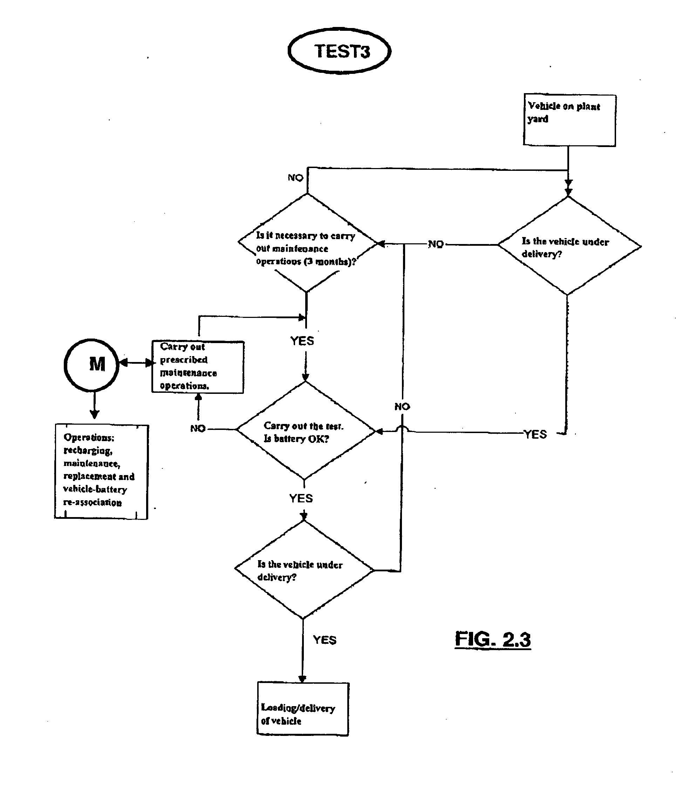

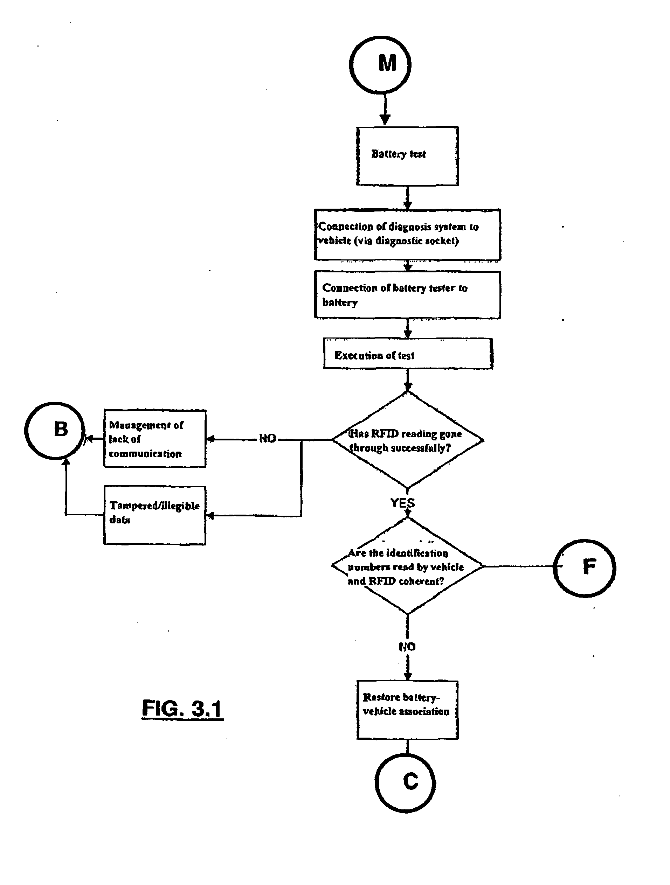

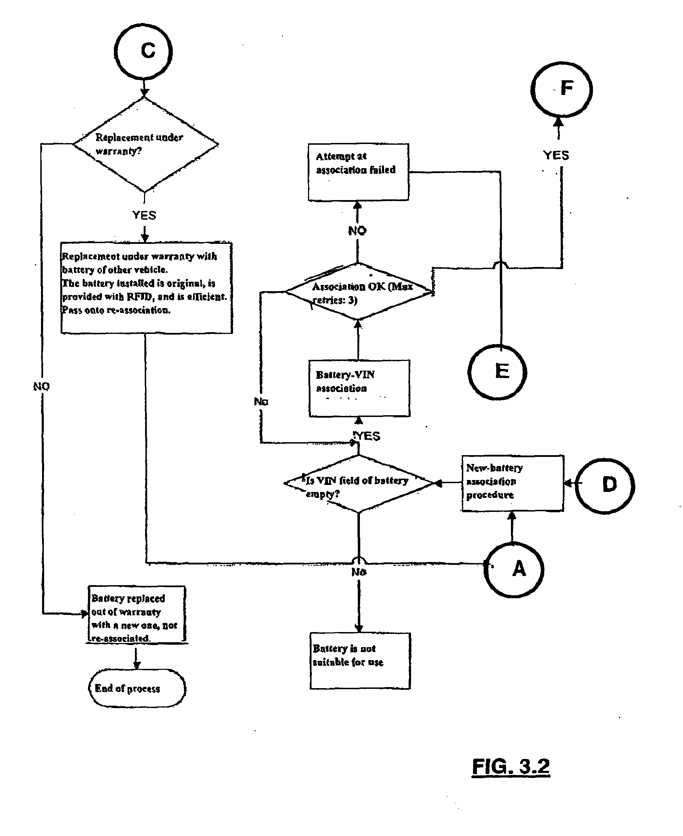

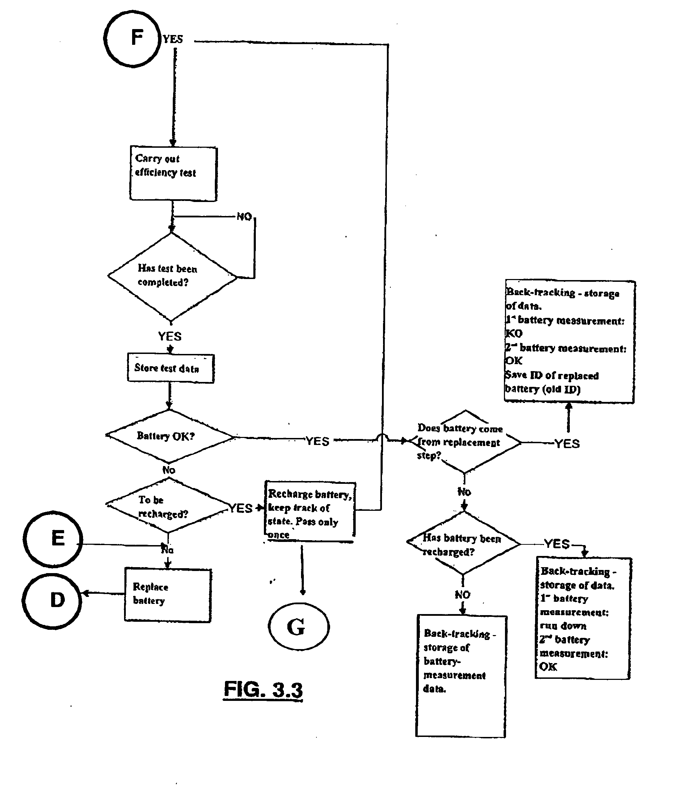

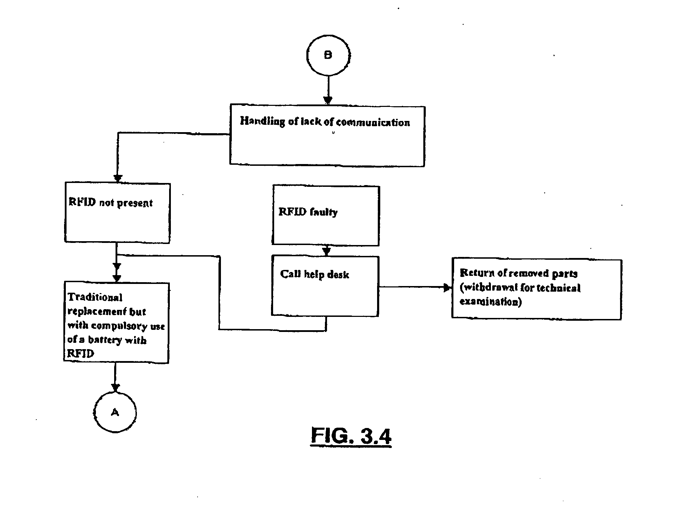

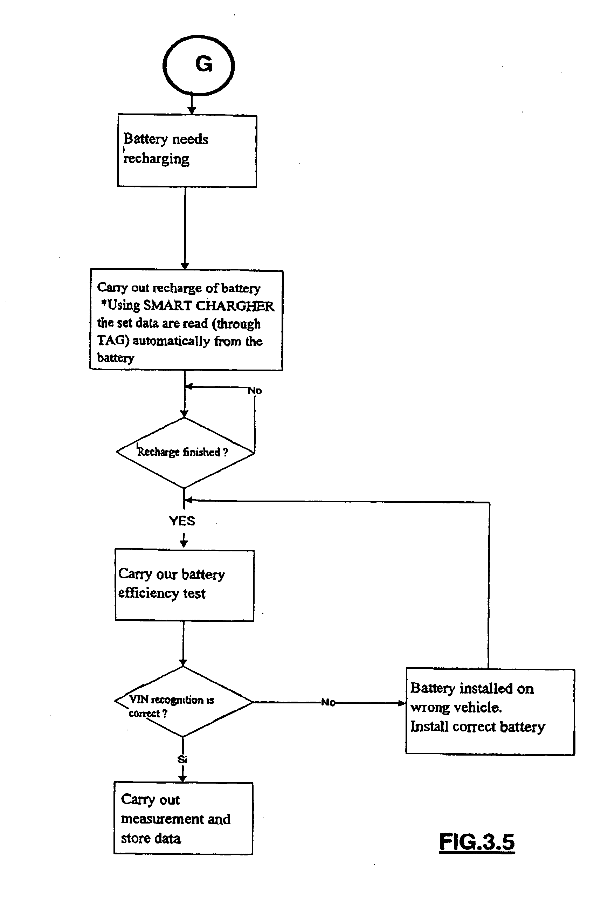

Described in greater detail in what follows is an embodiment of the flow of operations performed for analysing battery wear in accordance with the invention, with reference to Figures 2.1, 2.2, 2.3, 3.1, 3.2, 3.3, 3.4.

In effect, the main aspects of the details of the operative flows visible in the figures are described, said figures being self-explanatory for said details, which hence do not require any further detailed description in so far as the person skilled in the branch is perfectly able to implement them.

As already mentioned above, in the initial steps (step 1, fig. 1.1), at the time of production of the vehicle, identification numbers of vehicle characteristics and configuration are defined, such as, for example, VIN (Vehicle Identification Number) and PIC (Product ID Code). These numbers are uniquely associated to the battery by being written in the battery RFID TAG. Moreover the vehicle VEH RFID TAG is prepared. In the subsequent step (step 2, and RFID2, figures 2.1, 2.2), which may be at least partially contemporaneous to the step 1, the battery manufacturer and the vehicle manufacturer perform operations on the battery.

The battery manufacturer integrates the RFID TAG in the battery, where the data described above are stored, which are essentially relating to the battery identification.

After that, during the installation of the battery on the vehicle, the vehicle manufacturer adds to the RFID TAG the further data described above, which are essentially relating to the identification of the vehicle.

These steps include the verification of the correctness of the inserted data and of the relative writing procedure.

Operations of cross-checking of data identifying the vehicle and the battery may also be performed, for checking their proper association, e.g. to prevent non-authorized uses or replacements of the battery.
In case the vehicle VEH RFID TAG is placed near the battery RFID TAG, the identification data on all the RFID TAGs are simultaneously read and a cross-checking of the data is performed at the same time. If, on the contrary, the vehicle VEH RFID TAG is placed far from the battery RFID TAG, the identification data are first read on the vehicle VEH RFID TAG, by approaching the clamp with the integrated antenna, and are stored in the RFID R/W; then the clamp is placed in the battery compartment, for example by connecting it to the negative pole of a battery, and data is stored in RFID R/W, and after that a cross-checking is performed.

If the two vehicle identification numbers (VINs) of the vehicle and of the battery are the same, then the operations are correct; otherwise, an error is signalled in the process of maintenance, and for example the fault can be signalled to the centre.

In the subsequent steps of management of the vehicle being produced (site defined as "near plant") testing procedures start with data stored in the RFID TAGs (steps 3 and TEST3, Figures 2.1, 2.3). The procedures are periodic (for example, once every three months).

At a given moment, the vehicle leaves the production site possibly by means of a carrier, who delivers it definitively to a dealer or else temporarily to a body builder or else to the end customer (see the next steps in Figure 2.1).

Also in these steps, the periodic procedures of check on the state of maintenance and efficiency of the batteries are in any case performed, said procedures being represented in detail in the flowcharts of Figures 3.1∼3-4, which start by picking up from point M (Figure 2.3).

The operations may comprise recharging, replacement, vehicle-battery re-association, re-assignment of codes identifying the new battery, which may have been installed regularly or not, on the basis of the individual program for programmed maintenance.

More in particular, at each verification the test system is connected to the first of the vehicle batteries, then repeating the operations for each battery.

The frequency (e.g. once every 3 months) of the maintenance operations is checked, and warning signals are emitted when the maintenance date approaches.
The proper connection of all the RFID TAGs (one for each battery plus the one of the vehicle) with the antenna of the tester is checked, the correspondence of the relative identification codes is also checked. If the verifications are negative, the inserted data will be corrected by restoring the proper data association, or the battery(ies) will be replaced.

The warranty conditions are checked.
Test operation are performed, verifying the correctness of the measured parameters, such as for example tension, short-circuit current, temperature.

Then the measured parameters are stored in the RFID TAG in a encrypted way.

The state of charge of the battery is also checked. If the battery needs to be charged, it is possible to use a smart charger, which is able to communicate with the RFID TAG and to acquire the rating of the battery in order to automatically set the proper tension and current values to be used for the recharging, to optimize the recharging procedure and to avoid manual intervention.

The functions described above may be realized by means of computer programs, that may reside in one or more electronic processing means, integrated together or divided into cooperating different units. Said computer programs comprise code means suitable for performing one or more steps of the functions described above, when these programs are run on a computer.

For this reason the scope of the present invention is meant to cover also said computer programs and the computer-readable media that comprise a recorded message, said computer-readable media comprising the program code means for performing one or more steps of the functions described above, when such program is run on a computer.

It will be apparent to the person skilled in the art that other alternative and equivalent embodiments of the invention can be conceived and reduced to practice without departing from the scope of the invention.

There clearly emerge the advantages deriving from application of the present invention, as follows:
- maximization of the working life of the battery components;
- minimization of the replacements of the batteries for reasons of inadequate maintenance;
- reduction of the cases of the vehicle being out of running order owing to unforeseen faults of the battery;
- reduction of the cases of inefficiency and risks of unusability;
- provision of a diagnostic apparatus that identifies whether the battery is still compatible with the vehicle characteristics;
- feedback to design department for product improvements;
- feedback to the user in order to correct any possible energy abuse of the vehicle;
- reduction in costs for the user due to the vehicle being out of running order;
- reduction of the environmental impact owing to optimization of the use of the batteries.

From the description set forth above it will be possible for the person skilled in the art to embody the invention with no need of describing further construction details. In particular the realization of the computer programs may be carried out on the basis of programming languages known in the art, of any of the types used in the application field of this invention.

## Claims

1. System for analysing the state of maintenance and efficiency of vehicular batteries, especially for industrial and/or commercial vehicles, said system comprising:
- one first RFID TAG designed to be integrated in each of said vehicular batteries (BAT), said first RFID TAG being designed to store the data on the maintenance operations and identification information of the battery;
- at least one second RFID TAG designed to be placed in the vehicle, at least said one second RFID TAG being designed to store identification information of the vehicle; said first RFID TAG is also designed to store the identification information of the vehicle;
- one or more measuring instruments (TST) having clamps (CLP) and designed to make measurements of characteristic parameters of said batteries;
- one or more read/write devices (RFID R/W), connected to said one or more measuring instruments (TST), designed to read and write said data from/in said first and second RFID TAGs, and to compare the reciprocal correspondence between said identification information in first and second RFID TAGs
**Characterized in that**
said read/write devices (RFID R/W) have an antenna (ANT) integrated in the clamps (CLP) and **in that** said read/write devices (RFID R/W) are inserted in the splitting point of a connection cable between the measuring instruments (TST) and the clamps (CLP), where the cable is split in two ends, one for each clamp, such as the length of the portion of cable between the read/write devices (RFID R/W) and the antenna is predetermined and limited, in order to link the distance of the clamps (CLP), to the emission characteristics of the antenna.

2. The system for analysing the state of maintenance and efficiency of vehicular batteries as per Claim 1, moreover comprising a vehicle diagnostic platform (PDV), designed to interface with vehicle control units for reading vehicle parameters (PV), and designed to interface with said one or more read/write devices (RFID R/W) for reading said information in one or more RFID TAGs and for determining information for keeping track of the battery-maintenance operations.

3. System for analysing the state of maintenance and efficiency of vehicular batteries as per Claim 2, moreover comprising:
- an external information system (SIE), designed to control said vehicle diagnostic platform (PDV).
- a centralized server, for enabling storage of the data obtained, designed to interact with one or more vehicle diagnostic platforms (PVD) or with the external information system (SIE).

4. System for analysing the state of maintenance and efficiency of vehicular batteries as per Claim 3, further comprising a smart charger device (SMART CHARGER) able to communicate with said first RFID TAG in one or more vehicular batteries (BAT), and to acquire the rating of the battery in order to automatically set the proper tension and current values to be used for the recharging.

5. System for analysing the state of maintenance and efficiency of vehicular batteries as per Claim 1, in which said first RFID TAG is integrated in the vehicular batteries (BAT).

6. System for analysing the state of maintenance and efficiency of vehicular batteries as per Claim 5, in which said first RFID TAG is integrated in the lid of the vehicular battery (BAT) substantially vertically, with possible bar code as redundant identification.

7. System for analysing the state of maintenance and efficiency of vehicular batteries as per Claim 5, in which said first RFID TAG is floating within the battery liquid, or adhesive with protective coatings.

8. The system for analysing the state of maintenance and efficiency of vehicular batteries as per Claim 1, in which antenna (ANT) is embedded in the clamps (CLP) for connection to the negative battery terminal to provide a short-range communication, in presence of said connection.

## Patentansprüche

1. System zum Analysieren des Wartungs- und Leistungs-Zustandes von Fahrzeug-Batterien, speziell für Industrie- und/oder Nutz-Fahrzeuge, wobei das System umfaßt:
- einen ersten RFID TAG, der dafür ausgelegt ist, in jede der Fahrzeug-Batterien (BAT) integriert zu werden, wobei der erste RFID TAG dafür ausgelegt ist, die Daten von den Wartungs-Arbeiten und Identifikations-Information der Batterie zu speichern;
- wenigstens einen zweiten RFID TAG, der dafür ausgelegt ist, in dem Fahrzeug platziert zu werden, wobei der wenigstens eine zweite RFID TAG dafür ausgelegt ist, Identifikations-Information des Fahrzeugs zu speichern, wobei der erste RFID TAG auch dafür ausgelegt ist, die Identifikations-Information des Fahrzeugs zu speichern;
- ein oder mehr Meßinstrumente (TST), die Klammern (CLP) aufweisen und dafür ausgelegt sind, Messungen charakteristischer Parameter der Batterien durchzuführen;
- ein oder mehr Lese-/Schreib-Vorrichtungen (RFID R/W), die mit dem einen oder mehr Meßinstrumenten (TST) verbunden ist/sind, ausgelegt dafür, die Daten von/in den ersten und zweiten RFID TAGs zu lesen und zu schreiben und die wechselseitige Übereinstimmung zwischen der Identifikations-Information in den ersten und zweiten RFID TAGs zu vergleichen;
**dadurch gekennzeichnet, daß**
die Lese-/Schreib-Vorrichtungen (RFID R/W) eine in die Klammern (CLP) integrierte Antenne (ANT) aufweisen und daß die Lese-/Schreib-Vorrichtungen (RFID R/W) in den Aufspaltungs-Punkt eines Verbindungs-Kabels zwischen den Meßinstrumenten (TST) und den Klammern (CLP) eingesetzt sind, wo das Kabel in zwei Enden aufgespalten ist, eines für jede Klammer, so wie die Länge des Teils des Kabels zwischen den Lese-/Schreib-Vorrichtungen (RFID R/W) und der Antenne vorbestimmt und begrenzt ist, um die Entfernung der Klammern (CLP) zu den charakteristischen Emissions-Eigenschaften der Antenne zu verbinden.

2. System zum Analysieren des Wartungs- und Leistungs-Zustandes von Fahrzeug-Batterien nach Anspruch 1, darüber hinaus umfassend eine Fahrzeug-Diagnose-Plattform (PDV), ausgelegt dafür, mit Fahrzeug-Steuer-Einheiten zum Lesen von Fahrzeug-Parametern (PV) in Verbindung zu treten, und ausgelegt dafür, mit der einen oder mehr Lese-/Schreib-Vorrichtungen (RFID R/W) in Verbindung zu treten, zum Lesen der Information in einem oder mehr RFID TAGs und zum Ermitteln von Information zum Behalten des Überblicks über die Batterie-Wartungs-Vorgänge.

3. System zum Analysieren des Wartungs- und Leistungs-Zustandes von Fahrzeug-Batterien nach Anspruch 2, darüber hinaus umfassend:
- ein externes Informations-System (SIE), ausgelegt zum Steuern der Fahrzeug-Diagnose-Plattform (PDV);
- einen zentralen Server, um ein Speichern der erhaltenen Daten zu ermöglichen, und ausgelegt dafür, mit einem oder mehr Fahrzeug-Diagnose-Plattformen (PDV) oder mit dem externen Informations-System (SIE) zu interagieren.

4. System zum Analysieren des Wartungs- und Leistungs-Zustandes von Fahrzeug-Batterien nach Anspruch 3, darüber hinaus umfassend eine intelligente Lader-Vorrichtung (SMART CHARGER), die befähigt ist, mit dem ersten RFID TAG in einer oder mehr Fahrzeug-Batterien (BAT) zu kommunizieren und die Leistungsbeurteilung der Batterie zu erfahren, um automatisch die passenden Spannungs- und Strom-Werte festzulegen, die für das Wiederaufladen verwendet werden sollen.

5. System zum Analysieren des Wartungs- und Leistungs-Zustandes von Fahrzeug-Batterien nach Anspruch 1, in dem der erste RFID TAG in den Fahrzeug-Batterien (BAT) integriert ist.

6. System zum Analysieren des Wartungs- und Leistungs-Zustandes von Fahrzeug-Batterien nach Anspruch 5, in dem der erste RFID TAG in dem Deckel der Fahrzeug-Batterien (BAT) im Wesentlichen vertikal integriert ist, mit einem möglichen Bar-Code als redundanter Identifizierung.

7. System zum Analysieren des Wartungs- und Leistungs-Zustandes von Fahrzeug-Batterien nach Anspruch 5, in dem der erste RFID TAG in der Batterie-Flüssigkeit schwimmt oder anhaftend mit Schutzüberzügen ist.

8. System zum Analysieren des Wartungs- und Leistungs-Zustandes von Fahrzeug-Batterien nach Anspruch 1, in dem eine Antenne (ANT) in den Klammern (CLP) zum Anschließen an dem negativen Batterie-Pol eingebettet ist und so bei Vorhandensein des Anschlusses eine Verbindung auf kurze Entfernung liefert.

## Revendications

1. Système d'analyse de l'état de maintenance et du rendement de batteries véhiculaires, spécialement pour des véhicules industriels et/ou commerciaux, ledit système comprenant :
- une première ETIQUETTE RFID conçue pour être intégrée dans chacune desdites batteries véhiculaires (BAT), ladite première ETIQUETTE RFID étant conçue pour stocker des données sur les opérations de maintenance et des informations d'identification de la batterie ;
- au moins une deuxième ETIQUETTE RFID conçue pour être placée dans le véhicule, ladite au moins une deuxième ETIQUETTE RFID étant conçue pour stocker des informations d'identification du véhicule ; ladite première ETIQUETTE RFID est également conçue pour stocker les informations d'identification du véhicule ;
- un ou plusieurs instruments de mesure (TST) ayant des fixations (CLP) et conçus pour effectuer des mesures de paramètres caractéristiques desdites batteries ;
- un ou plusieurs dispositifs de lecture/écriture (R/W RFID), raccordés auxdits un ou plusieurs instruments de mesure (TST), conçus pour lire et écrire lesdites données à partir de/dans lesdites première et deuxième ETIQUETTES RFID, et pour comparer la correspondance réciproque entre lesdites informations d'identification des première et deuxième ETIQUETTES RFID,
**caractérisé en ce que**
lesdits dispositifs de lecture/écriture (R/W RFID) ont une antenne (ANT) intégrée dans les fixations (CLP) et **en ce que** lesdits dispositifs de lecture/écriture (R/W RFID) sont insérés dans le point de séparation d'un câble de connexion entre les instruments de mesure (TST) et les fixations (CLP), où le câble est séparé en deux extrémités, une pour chaque fixation, de telle sorte que la longueur de la portion de câble entre les dispositifs de lecture/écriture (R/W RFID) et l'antenne est prédéterminée et limitée, afin de lier la distance des fixations (CLP) aux caractéristiques d'émission de l'antenne.

2. Système d'analyse de l'état de maintenance et du rendement de batteries véhiculaires selon la revendication 1, comprenant en outre une plateforme de diagnostic de véhicule (PDV), conçue pour servir d'interface avec des unités de commande de véhicule pour la lecture de paramètres de véhicule (PV), et conçue pour servir d'interface avec lesdits un ou plusieurs dispositifs de lecture/écriture (R/W RFID) pour la lecture desdites informations dans une ou plusieurs ETIQUETTES RFID et pour la détermination d'informations permettant de suivre les opérations de maintenance de batterie.

3. Système d'analyse de l'état de maintenance et du rendement de batteries véhiculaires selon la revendication 2, comprenant en outre :
- un système d'information externe (SIE), conçu pour commander ladite plateforme de diagnostic de véhicule (PDV),
- un serveur centralisé, permettant le stockage des données obtenues, conçu pour interagir avec une ou plusieurs plateformes de diagnostic de véhicule (PVD) ou avec le système d'information externe (SIE).

4. Système d'analyse de l'état de maintenance et du rendement de batteries véhiculaires selon la revendication 3, comprenant en outre un dispositif de chargeur intelligent (CHARGEUR INTELLIGENT) pouvant communiquer avec ladite première ETIQUETTE RFID dans une ou plusieurs batteries véhiculaires (BAT) et acquérir la puissance nominale de la batterie afin d'établir automatiquement les valeurs correctes de tension et de courant à utiliser pour le rechargement.

5. Système d'analyse de l'état de maintenance et du rendement de batteries véhiculaires selon la revendication 1 dans lequel ladite première ETIQUETTE RFID est intégrée dans les batteries véhiculaires (BAT).

6. Système d'analyse de l'état de maintenance et du rendement de batteries véhiculaires selon la revendication 5, dans lequel ladite première ETIQUETTE RFID est intégrée dans le couvercle de la batterie véhiculaire (BAT), sensiblement verticalement, avec un code-barres éventuel en tant qu'identification redondante.

7. Système d'analyse de l'état de maintenance et du rendement de batteries véhiculaires selon la revendication 5, dans lequel ladite première ETIQUETTE RFID flotte dans le liquide de la batterie, ou est adhésive avec des revêtements protecteurs.

8. Système d'analyse de l'état de maintenance et du rendement de batteries véhiculaires selon la revendication 1, dans lequel une antenne (ANT) est incorporée dans les fixations (CLP) pour une connexion à la borne de batterie négative afin de fournir une communication de courte distance, en présence de ladite connexion.
